# EUROPEAN PATENT SPECIFICATION

(11) **EP 1 111 977 B1**
(45) Date of publication and mention of the grant of the patent: **04.05.2005**
(21) Application number: 01104395.7
(22) Date of filing: 27.10.1998
(51) Int. Cl.: H05K 7/10, H01R 13/24

(54) **Interposer assembly**
Zwischenstück
Pièce d'interposition

(30) Priority: 30.10.1997 US 960953
(43) Date of publication of application: 27.06.2001
(62) Divisional of application: 98308773.5
(73) Proprietor: Intercon Systems, Inc., Harrisburg, Pennsylvania 17110-9310 (US)
(72) Inventor: Neidich, Douglas A., Harrisburg, Pennsylvania 17331 (US); Walden, John D., Mechanicsburg, Pennsylvania 17055 (US)
(74) Representative: Lippich, Wolfgang, Dipl.-Phys, Dr.rer.nat.

(56) References cited:
- EP-A- 0 742 682
- DE-A- 4 039 009
- US-A- 5 342 205
- US-A- 5 653 598

## Description

The invention relates to interposer assemblies used for forming electrical connections between contact pads on circuit members.

Interposer assemblies are used for forming electrical connections between densely spaced contact pads on adjacent parallel circuit members. The pads on the members are arranged in identical patterns. Commonly, the circuit members are a circuit board and a ceramic plate carrying integrated circuits. The interposer assembly includes an insulating plate and a plurality of through-contacts carried in the plate and arranged in the same pattern as the pads on the circuit members. The contacts project above the top and bottom of the plate. The assembly is sandwiched between the two members which are held together with the contacts forming electric connections between appropriate aligned pairs of pads.

Interposer assemblies are used for forming electrical connections between contact pads arranged in a very close proximity to each other. The pads may be arranged on a one millimeter center-to-center grid. In addition to requiring contacts which can be spaced very close to each other, the contacts must form reliable electrical connections with the pads when the assemblies are sandwiched between the circuit members. A low mechanical closure force is required in order to prevent undue stress to a ceramic circuit member. A high closure force could distort or possibly break the ceramic member. Further, interposer assemblies must occupy a minimum width space between the circuit members, requiring that the individual electrical contacts in the assembly have a limited height yet possess the required spring properties for establishing reliable electrical connections between the pads without undue closing force.

Conventional interposer assemblies use terminals which occupy a relatively large amount of space in the supporting plate making it difficult to meet closely spaced grid requirements. These assemblies are relatively expensive to manufacture and assemble.

The invention is an improved interposer assembly including metal contacts loosely confined in closely spaced passages extending through an insulating plate. The contacts include arcuate spring portions which are elastically bent to form wiped connections with the pads and reduce the force necessary to sandwich the interposer assembly between the circuit members. The low closure force reduces the risk of damage to an overlying ceramic substrate and allows a large number of contacts in the assembly. The wiped electrical connections between the contacts and the circuit pads form reliable electrical connections between the adjacent pairs of pads and permit installation of the interposer assemblies in user's facilities. The assemblies need not,be installed in clean rooms.

The disclosed interposer assembly uses plates and contacts which are easily and inexpensively manufactured and assembled. The plate is a one-piece design and includes through passages having opposed sides extending between the top and bottom of the plate with contact retention projections extending into the passages from one of said sides between the top and bottom of the plate. One side of each passage is wider than the other side of the passage and the contact adjacent said one passage side is wider than the contact adjacent the other side of the passage. The contacts are formed to engage with the projections and are readily inserted into the passages to snap or latch over the projections, which then hold the contacts loosely in place in the passages prior to sandwiching of the assemblies between circuit members. The contacts are compact, permitting use of the assembly to form electrical connections between very closely spaced contact pads.

Other objects and features of the invention will become apparent as the description proceeds, especially when taken in conjunction with the accompanying drawings illustrating the invention, of which there are three sheets and one embodiment.
Figure 1 is a top view of an interposer assembly per the invention;
Figure 2 is a sectional view taken along line 2--2 of Figure 1;
Figure 3 is a sectional view illustrating the position of the assembly between two circuit members;
Figure 4 is a view like Figure 3 showing the assembly sandwiched between the circuit members;
Figure 5 is a perspective view of a contact used in the assembly; and
Figure 6 is a sectional view illustrating insertion of the contact member into a passage through the plate.

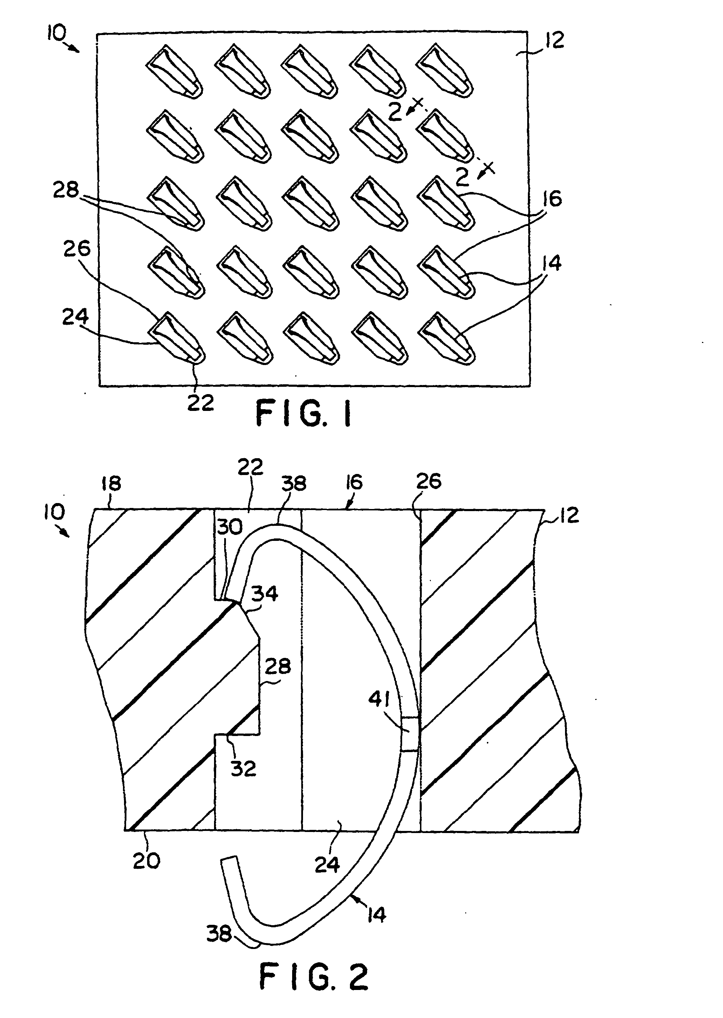

Interposer assembly 10 includes a flat plate 12 formed of insulating material with a plurality of metal contacts 14 positioned in passages 16 extending through the thickness of the plate between opposed plate top and bottom surfaces 18 and 20. As shown in Figure 1, passages 16 are each provided with a reduced width side 22 and a uniform width portion 24 away from side 22. Flat side wall 26 extends across the uniform width portions 24 opposite the reduced width side 22.

Contact retention projections are provided in the reduced width sides 22 of passages 16. Projections 28 extend a distance into the passages and include contact retention surfaces 30 and 32 facing plate top and bottom 18 and 20, respectively. The surfaces 30 and 32 are spaced in from the top and bottom of the plate. A sloped cam surface 34 extends from each retention surface 30 to the inner end of the projection 28 and faces top 18. Surface 34 facilitates insertion of contact 14 into passage 16.

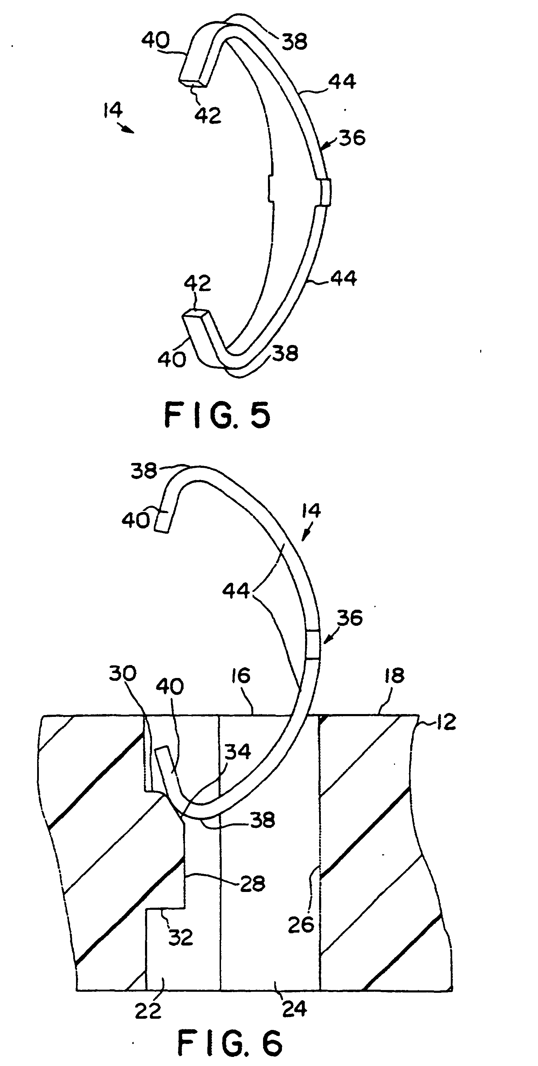

Each metal contact 14 is preferably formed from uniform thickness strip stock, which may be suitably plated beryllium copper. The contact is generally D-shaped, and includes a arcuate, convex spring 36 with a pair of opposed contact noses 38 at the ends of the springs. The noses are spaced apart a distance greater than the thickness of the plate 12. Short retention legs 40 extend inwardly from the noses to free ends 42. The legs 40 extend away from spring 36 so that the noses 38 are located between the free ends 42 and the spring. As illustrated in Figure 5, spring 36 has a maximum width midway between noses 38 and includes two tapered width spring portions or arms 44 each extending from the center of the spring to a nose 38, in order to reduce stress concentration when the spring is stressed.

Contacts 14 are inserted into passages 16 as shown in Figure 6. One nose of the contact is extended into the end of the passage opening at plate top 18 and is positioned between the projection 28 and end wall 26. The contact is inserted into the passage and leg 40 is guided by surface 34 to the end of the projection and spring 36 engages wall 26. The contact is then inserted further into the passage with the result that the lower spring arm 44 is elastically stressed, leg 40 is moved past projection 28 and snaps back under retention surface 32. With the contact inserted in passage 16 end 42 of the upper retention leg 40 is above the upper retention surface 30, end 42 of the lower retention leg 40 is located below the lower retention surface 32 and the center 41 of the arcuate spring is adjacent the flat end wall 26. Spring 36 is bowed toward wall 26. The contact is loosely held in the passage between side 22 and side wall 26. The distance between the free ends 42 of legs 40 is greater, than the length of projection 28, permitting limited free movement of the contact in passage 16. Figure 2 illustrates the position of the contact in the passage when plate 12 is horizontal and the loose contact 14 is supported in the cavity against gravity with the end of the upper leg 40 resting on upper retention surface 30 of projection 28.

As illustrated in Figure 1, the passages 16 are arranged close to each other in a dense array on plate 12 in order to permit forming of electrical connections between similar arrays of contact pads on circuit elements located above and below the assembly. Conventionally, assembly 10 is used for forming electrical connections between contact pads on a ceramic integrated circuit and contact pads of a circuit board. The assembly may be used for forming electrical connections between contact pads on two circuit boards or between contact pads on other types of circuit members.

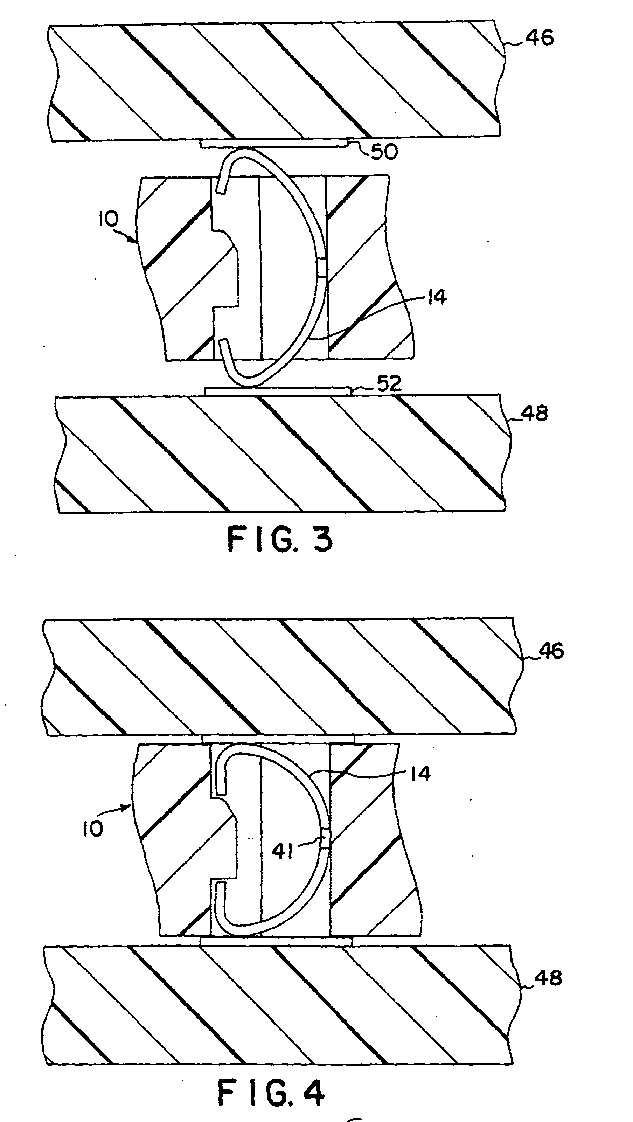

Figure 3 illustrates the interposer assembly 10 positioned between upper and lower circuit members 46 and 48 with contact pads 50 and 52 on the members located above and below each contact in the assembly. The contacts lightly engage the pads and are not stressed.

Figure 4 illustrates the assembly 10 when fully sandwiched between member 46 and 48 with the members held tightly against the assembly plate 12. When the members are brought into contact with the assembly 10 the two contact pads 50 and 52 are moved together to reduce the height of contacts 14 and elastically bend the two tapered spring arms 44 of arcuate spring 36. The center of the spring engages the side wall 26 as shown in Figure 4. Bending of the arcuate spring and foreshortening of the contact moves or wipes the contact noses 38 a distance along the contact pads toward side 22 to make clean, low resistance pressure electrical connections between the contact noses 38 and the pads 50 and 52. The connections assure that the contact 14 provides a reliable, low resistance electrical path between the pads.

As illustrated in Figure 4, foreshortening of contact 14 moves the free ends 42 of retention legs 40 together and brings the ends in close proximity to the retention surfaces 30 and 32 of projection 28. The retention legs do not engage the projection. Contact pressure is maintained by elastic bending of the spring 36 without bottoming of the ends of the contact on the projection or the walls of passage 16 which could undesirably increase the closing force.

While we have illustrated and described a preferred embodiment of our invention, it is understood that this is capable of modification, and we therefore do not wish to be limited to the precise details set forth, but desire to avail ourselves of such changes and alterations as fall within the purview of the following claims.

## Claims

1. An interposer assembly comprising an insulating plate having a plurality of passages extending through the thickness of the plate, each passage having opposed sides (22, 26) extending between the top and bottom of the plate (12), a projection (28) extending into said passage from one of said sides between the top and bottom of the plate, and a plurality of metal contacts (14), each contact including a spring (36), contact noses (38) at the ends of the spring and free ends located closer together than the noses, each contact being formed to engage with said projection to be confined in the passage, said noses (38) spaced apart a distance greater than the thickness of the plate, with portions of each contact located on opposite sides of a projection, one side of the passage (26) is wider than the other side of the passage (22) and the contact adjacent said one passage side (26) is wider than the contact adjacent the other side of the passage.

2. An interposer assembly as in claim 1 wherein each contact, when unstressed, is loosely held in a passage.

3. An interposer assembly as in any preceding claim wherein each spring includes two tapered spring arms, each spring arm extending from the center of the spring to a nose.

4. An interposer assembly as in claim 3 wherein each contact is formed from uniform thickness strip stock and the width of each spring arm decreases from the center of the contact to a nose.

5. An interposer assembly as in any preceding claim wherein each projection includes a contact cam surface facing one side of the plate and a contact retentiop surface facing the other side of the plate.

6. An interposer assembly as in claim 5 wherein each cam surface is sloped.

7. An interposer assembly as in any preceding claim wherein each projection is located at the other side of a passage.

8. An interposer assembly as in any preceding claim wherein each passage includes a uniform width portion adjacent the one passage side and a reduced width portion adjacent the other passage side.

## Patentansprüche

1. Zwischenschaltungs-Baugruppe umfassend eine isolierende Platte, mit einer Anzahl von sich durch die Dicke der Platte erstreckenden Durchgängen, wobei jeder Durchgang sich zwischen der Oberseite und der Unterseite der Platte (12) erstreckende gegenüberliegende Seiten (22, 26) aufweist, wobei sich ein Vorsprung (28) von einer der Seiten zwischen der Oberseite und der Unterseite der Platte in den Durchgang erstreckt, und mit einer Anzahl von Metallkontakten (14), wobei jeder Kontakt eine Feder (36), Kontaktnasen (38) an den Enden der Feder und näher beieinander als die Nasen befindliche freie Enden enthält,
wobei jeder Kontakt so ausgebildet ist, dass er an den Vorsprung angreift, so dass er in dem Durchgang gefangen ist,
wobei die Nasen (38) um eine größere Entfernung als die Dicke der Platte voneinander beabstandet sind, wobei Bereiche eines jeden Kontakts an entgegengesetzten Seiten eines Vorsprungs befindlich sind, eine Seite des Durchgangs (26) breiter ist als die andere Seite des Durchgangs (22) und der Kontakt nahe der einen Durchgangsseite (26) breiter als der Kontakt nahe der anderen Seite des Durchgangs ist.

2. Zwischenschaltungs-Baugruppe nach Anspruch 1, wobei jeder Kontakt, wenn er unbelastet ist, lose in einem Durchgang gehalten ist.

3. Zwischenschaltungs-Baugruppe nach einem der vorhergehenden Ansprüche, wobei jede Feder zwei sich verjüngende Federarme enthält, wobei sich jeder Federarm von der Mitte der Feder zu einer Nase erstreckt.

4. Zwischenschaltungs-Baugruppe nach Anspruch 3, wobei jeder Kontakt aus Streifenmaterial gleichförmiger Dicke gebildet ist und die Breite eines jeden Federarms von der Mitte des Kontakts zu einer Nase abnimmt.

5. Zwischenschaltungs-Baugruppe nach einem der vorhergehenden Ansprüche, wobei jeder Vorsprung eine Kontaktnockenfläche, die einer Seite der Platte zugewandt ist, und eine Kontakthaltefläche, die der anderen Seite der Platte zugewandt ist, enthält.

6. Zwischenschaltungs-Baugruppe nach Anspruch 5, wobei jede Nockenfläche abgeschrägt ist.

7. Zwischenschaltungs-Baugruppe nach einem der vorhergehenden Ansprüche, wobei jeder Vorsprung an der anderen Seite eines Durchgangs befindlich ist.

8. Zwischenschaltungs-Baugruppe nach einem der vorhergehenden Ansprüche, wobei jeder Durchgang einen Bereich gleichförmiger Breite nahe der einen Durchgangsseite und einen Bereich verminderter Breite nahe der anderen Durchgangsseite enthält.

## Revendications

1. Pièce d'interposition comprenant une plaque isolante, comprenant une pluralité de passages, s'étendant à travers l'épaisseur de la plaque, chaque passage ayant des côtés (22, 26) opposés, s'étendant entre la partie supérieure et inférieure de la plaque (12), une saillie (28) s'étendant dans ledit passage depuis l'un desdits côtés, entre la partie supérieure et inférieure de la plaque, et une pluralité de contacts métalliques (14), chaque contact comprenant un ressort (36), des ergots de contact (38) aux extrémités du ressort et des extrémités libres placées plus près les unes des autres que le sont les ergots, chaque contact étant formé pour venir en prise avec ladite saillie devant être confinée dans le passage, lesdits ergots (38) étant espacés d'une distance supérieure à l'épaisseur de la plaque, des parties de chaque contact étant placée sur des côtés opposés d'une saillie, un côté du passage (26) étant plus large que l'autre côté du passage (22) et le contact adjacent audit premier côté de passage (26) étant plus large que le contact adjacent à l'autre côté du passage.

2. Pièce d'interposition selon la revendication 1, dans laquelle chaque contact, une fois relaxé, est maintenu de façon lâche dans un passage.

3. Pièce d'interposition selon l'une quelconque des revendications précédentes, dans laquelle chaque ressort comprend deux bras de ressort effilés, chaque bras de ressort s'étendant depuis le centre du ressort vers un ergot.

4. Pièce d'interposition selon la revendication 3, dans laquelle chaque contact est formé d'un matériau en bande, d'épaisseur uniforme, et la largeur de chaque bras de ressort va en diminuant en allant du centre du contact vers un ergot.

5. Pièce d'interposition selon l'une quelconque des revendications précédentes, dans laquelle chaque saillie comprend une surface formant came de contact, tournée vers un côté de la plaque, et une surface de rétention de contact, tournée vers l'autre côté de la plaque.

6. Pièce d'interposition selon la revendication 5, dans laquelle chaque surface de came est inclinée.

7. Pièce d'interposition selon l'une quelconque des revendications précédentes, dans laquelle chaque saillie est placée sur l'autre côté d'un passage.

8. Pièce d'interposition selon l'une quelconque des revendications précédentes, dans laquelle chaque passage comprend une partie à largeur uniforme, adjacente à un premier côté de passage, et une partie à largeur réduite, adjacente à l'autre côté de passage.
